(19) 

Europäisches
Patentamt
European
Patent Office
Office européen
des brevets

(11) **EP 4 503 121 A1**

(12) **EUROPEAN PATENT APPLICATION**
published in accordance with Art. 153(4) EPC

(43) Date of publication:
**05.02.2025 Bulletin 2025/06**

(21) Application number: **23780596.5**

(22) Date of filing: **28.03.2023**

(51) International Patent Classification (IPC):
**H01L 23/373** (2006.01)    **H05K 7/20** (2006.01)

(52) Cooperative Patent Classification (CPC):
**H01L 23/373; H05K 7/20**

(86) International application number:
**PCT/JP2023/012651**

(87) International publication number:
**WO 2023/190587 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2022   JP 2022054428**

(71) Applicant: **Sekisui Polymatech Co., Ltd.
Saitama-city, Saitama 338-0837 (JP)**

(72) Inventors:
• **IWAZAKI, Hiromichi
  Saitama-city, Saitama 338-0837 (JP)**
• **KUROO, Kenta
  Saitama-city, Saitama 338-0837 (JP)**
• **KUDOH, Hiroki
  Saitama-city, Saitama 338-0837 (JP)**

(74) Representative: **Ter Meer Steinmeister & Partner
Patentanwälte mbB
Nymphenburger Straße 4
80335 München (DE)**

(54) **THERMALLY CONDUCTIVE SHEET AND METHOD FOR PRODUCING THERMALLY CONDUCTIVE SHEET**

(57) A thermally conductive sheet comprising a matrix formed of an organic polymer, and a fibrous filler, wherein a thickness of the thermally conductive sheet is less than 200 $\mu$m, the fibrous filler is oriented in a thickness direction of the thermally conductive sheet, and a ratio (D50/T) of an average fiber length D50 of the fibrous filler to the thickness of the thermally conductive sheet (T) is less than 0.58.

EP 4 503 121 A1

**Description**

Technical Field

The present invention relates to a thermally conductive sheet and a method for producing the thermally conductive sheet.

Background Art

In electronic devices, such as a computer, an automobile part, and a cellular phone, a heat-dissipating element, such as a heat sink, is generally used for dissipating heat which is generated from a heating element such as a semiconductor element or a mechanical part. It is known that a thermally conductive sheet is disposed between a heating element and a heat-dissipating element for the purpose of enhancing the efficiency of heat transfer to the heat-dissipating element.

Such a thermally conductive sheet is known to contain a thermally conductive filler such as a filler as a method for enhancing the efficiency of heat transfer. For example, PTL 1 discloses a thermally conductive sheet containing an anisotropic thermally conductive filler. PTL 1 describes that a carbon fiber having an average major axis length (an average fiber length) of 100 $\mu$m or more is used as the anisotropic thermally conductive filler, and when the fiber length is less than 100 $\mu$m, thermal conductive properties cannot sufficiently be obtained.

In addition, PTL 2 discloses an insulating high heat conductive sheet containing an insulating high heat conductive fiber. PTL 2 describes that, when the proportion of the thermally conductive fiber that penetrates through the insulating high heat conductive sheet is high, thermal conductive properties are excellent.

Further, PTL 3 discloses a thermally conductive sheet containing a carbon fiber. PTL 3 describes that, when the average fiber length of the carbon fiber is longer than 600 $\mu$m, the carbon fiber is bulky, and the viscosity of the composition to be a raw material for the thermally conductive sheet increases.

Citation List

Patent Literature

    PTL1: JP 6082777 B
    PTL2: JP 2017-135137 A
    PTL3: JP 6684408 B

Summary of Invention

Technical Problem

By the way, along with the miniaturization of electronic devices, semiconductor apparatuses, and the like, the thermally conductive sheet is desired to have a further low thermal resistance value and high efficiency of heat transfer, in recent years. It is known that the surface resistance and the thickness generally contribute to the thermal resistance value of the thermally conductive sheet. Although it is known that the former can be solved by reducing the surface roughness by polishing, the thermal resistance value has been largely improved so far by making the thermally conductive sheet thin due to the large contribution of the thickness.

However, it has been found by the examination by the present inventors that, when the conventional thermally conductive sheet is made thin to a certain thickness, the thermal resistance can be reduced as the thickness is made thin, but the thermal resistance surprisingly deteriorates when the thickness is made thin over a certain level.

Therefore, an object of the present invention is to provide a thermally conductive sheet having low thermal resistance even when the thickness of the thermally conductive sheet is made significantly thin.

Solution to Problem

The present inventors have intensively studied and found that, in a thermally conductive sheet in which the thickness is less than 200 $\mu$m, the above problem can be solved by setting a ratio of the average fiber length of the fibrous filler contained in the thermally conductive sheet to the thickness of the thermally conductive sheet to less than 0.58, thereby completing the present invention.

That is, the present invention provides the following [1] to [11].
[1] A thermally conductive sheet comprising a matrix formed of an organic polymer, and a fibrous filler, a thickness of the thermally conductive sheet being less than 200 μm, the fibrous filler being oriented in a thickness direction of the thermally conductive sheet, and a ratio (D50/T) of an average fiber length D50 of the fibrous filler to the thickness of the thermally conductive sheet (T) being less than 0.58.

[2] The thermally conductive sheet according to [1], wherein the average fiber length D50 of the fibrous filler is less than 85 μm.

[3] A thermally conductive sheet comprising a matrix formed of an organic polymer, and a fibrous filler, a thickness of the thermally conductive sheet being less than 200 μm, the fibrous filler being oriented in a thickness direction of the thermally conductive sheet, and an average fiber length D50 of the fibrous filler being 5 μm or more and less than 85 μm.

[4] The thermally conductive sheet according to any one of [1] to [3], wherein an average fiber length D90 of the fibrous filler is less than 135 μm.

[5] The thermally conductive sheet according to any one of [1] to [4], wherein at least one surface of the thermally conductive sheet is a polished surface.

[6] The thermally conductive sheet according to any one of [1] to [5], wherein the matrix is silicone rubber.

[7] The thermally conductive sheet according to any one of [1] to [6], wherein the matrix is in an amount of 20 to 50% by volume, and the thermally conductive sheet comprises 30 to 500 parts by mass of the fibrous filler based on 100 parts by mass of the matrix.

[8] The thermally conductive sheet according to any one of [1] to [7], further comprising a non-anisotropic filler.

[9] The thermally conductive sheet according to any one of [1] to [8], further comprising a flake-like filler.

[10] A method for producing the thermally conductive sheet according to any one of [1] to [9], comprising: a step of obtaining an oriented formed body from a mixed composition comprising a polymer composition and a fibrous filler, wherein the fibrous filler is oriented along one direction, and a step of cutting the oriented formed body into a sheet-like form to obtain a sheet-like formed body.

[11] The method for producing the thermally conductive sheet according to [10], comprising a step of polishing a surface of the thermally conductive sheet.

Advantageous Effects of Invention

According to the present invention, even when the thickness of the thermally conductive sheet is made significantly thin, the thermally conductive sheet having low thermal resistance can be provided.

Brief Description of Drawing

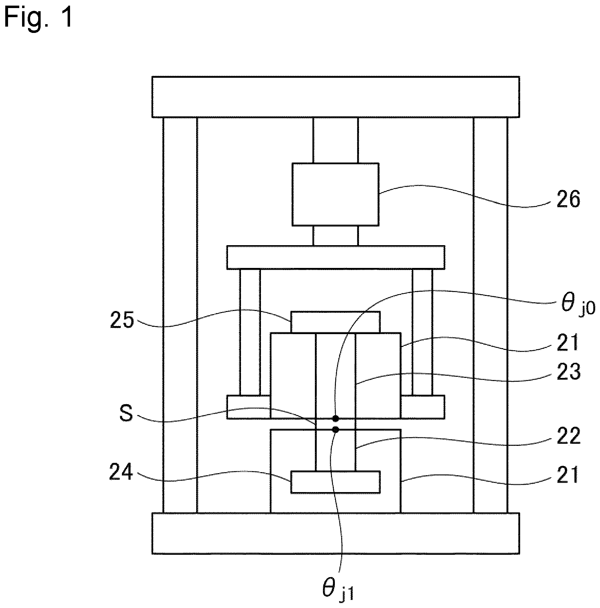

[Fig. 1] Fig. 1 is an outline diagram of a thermal resistance measuring machine.

Description of Embodiments

[Thermally Conductive Sheet]

Hereinafter, the thermally conductive sheet of the present invention will be described in detail with reference to the thermally conductive sheets of the first and second embodiments.

<First Embodiment>

The thermally conductive sheet according to the first embodiment of the present invention comprises a matrix formed of an organic polymer, and a fibrous filler is oriented in a thickness direction of the thermally conductive sheet.
In the present invention, the thickness of the thermally conductive sheet is less than 200 μm. When the thickness of the thermally conductive sheet exceeds 200 μm, the thermal resistance value of the thermally conductive sheet increases, so that thermal conductive properties cannot be sufficiently exerted. From such a viewpoint, the thickness of the thermally conductive sheet is preferably less than 180 μm, and more preferably less than 170 μm. On the other hand, the lower limit of the thickness of the thermally conductive sheet is not particularly limited, but is, for example, 40 μm or more, and preferably 70 μm or more in practical use.
From the above viewpoint, the thickness of the thermally conductive sheet is preferably 40 μm or more and less than 200 μm, more preferably 40 μm or more and less than 180 μm, and further preferably 70 μm or more and less than 170

μm.

The thickness of the thermally conductive sheet refers to the initial thickness measured in a state in which no load acts in the thickness direction.

(Fibrous Filler)

The fibrous filler is oriented in the thickness direction in the thermally conductive sheet. Herein, the state in which the fibrous filler is oriented in the thickness direction of the thermally conductive sheet refers to a state in which the major axis direction of the fibrous filler faces a direction in a range of within 20° from the thickness direction of the thermally conductive sheet, and when such a fibrous filler occupies a large part in the thermally conductive sheet (for example, more than 60%, preferably more than 80% based on the number of total fibrous fillers), the fibrous filler is considered to be oriented in the thickness direction. Such a state of orientation can be ascertained by observing a section cut along the thickness direction of the thermally conductive sheet with an electron microscope.

In the thermally conductive sheet according to the first embodiment of the present invention, the ratio of the average fiber length D50 of the fibrous filler to the thickness of the thermally conductive sheet (T) (hereinafter, also referred to as "D50/T") is less than 0.58. In a thermally conductive sheet having a significantly thin thickness as the present invention, when the average fiber length D50 of the fibrous filler contained in the thermally conductive sheet is long relative to the thickness of the sheet, the proportion of the dropping of the fibrous filler in the production stage of the thermally conductive sheet (for example, cutting and polishing steps) increases, which is estimated to cause deterioration of contact thermal resistance. Since the contact thermal resistance largely contributes to the thermal resistance value of the thermally conductive sheet having a small thickness, the deterioration of the contact thermal resistance is estimated to also reduce the thermal resistance value of the whole thermally conductive sheet.

Although the above phenomenon is significant upon use of a soft matrix such as rubber, it seems to be caused at a certain probability when the thickness of the sheet is thin, regardless of the type and amount of matrix.

From such a viewpoint, D50/T is preferably 0.57 or less, and more preferably 0.55 or less. The upper limit of D50/T is not particularly limited, but is, for example, 0.20 or more, preferably 0.30 or more, and more preferably 0.40 or more, from the viewpoint of making the fiber length of the fibrous filler long and thermal conductive properties good.

From the above viewpoint, D50/T is preferably 0.20 or more and less than 0.58, more preferably 0.30 or more and 0.57 or less, and further preferably 0.40 or more and 0.55 or less.

In the fibrous filler contained in the thermally conductive sheet of the present invention, the average fiber length D50 is less than 116 μm, preferably less than 85 μm, more preferably 84 μm or less, and further preferably 73 μm or less. Setting the average fiber length D50 to the above upper limit value or less suppresses the dropping of the fibrous filler and makes it easy to reduce the thermal resistance value of the thermally conductive sheet.

The lower limit of the average fiber length D50 of the fibrous filler is not particularly limited, but the average fiber length D50 is preferably 5 μm or more, more preferably 25 μm or more, and further preferably 35 μm or more. Setting the average fiber length D50 to the above lower limit value or more makes it easy to make the thermal conductive properties of the thermally conductive sheet good.

From the above viewpoint, the average fiber length D50 of the fibrous filler is preferably 5 μm or more and less than 116 μm, more preferably 5 μm or more and less than 85 μm, further preferably 25 μm or more and 84 μm or less, and further more preferably 35 μm or more and 73 μm or less.

The average fiber length D90 of the fibrous filler may be, for example, less than 150 μm, preferably less than 135 μm, more preferably 132 μm or less, and further preferably 125 μm or less. Setting the average fiber length D90 to the above upper limit value or less prevents fibrous fillers which are longer than needed from being contained, so that thermal resistance value can be further reduced.

The average fiber length D90 of the fibrous filler is preferably 10 μm or more, more preferably 50 μm or more, and further preferably 70 μm or more. Setting the average fiber length D90 to the above lower limit value or more makes it easy to make the thermal conductive properties of the thermally conductive sheet good.

From the above viewpoint, the average fiber length D90 of the fibrous filler is preferably 50 μm or more and less than 150 μm, more preferably 50 μm or more and less than 135 μm, further preferably 70 μm or more and 132 μm or less, and further more preferably 70 μm or more and 125 μm or less.

The average fiber length D10 of the fibrous filler may be, for example, less than 85 μm, preferably 55 μm or less, and further preferably 45 μm or less. Setting the average fiber length D10 to the above upper limit value or less makes it easy to suppress the dropping of the fibrous filler, so that the thermal resistance value of the thermally conductive sheet is easily reduced.

The average fiber length D10 of the fibrous filler is preferably 3 μm or more, more preferably 15 μm or more, and further preferably 20 μm or more. Setting the average fiber length D10 to the above lower limit value or more prevents fibrous fillers which are shorter than needed from being contained, and makes it easy to make the thermal conductive properties of the thermally conductive sheet good.

From the above viewpoint, the average fiber length D10 of the fibrous filler is preferably 3 $\mu$m or more and less than 85 $\mu$m, more preferably 15 $\mu$m or more and 55 $\mu$m or less, and further preferably 20 $\mu$m or more and 45 $\mu$m or less.

D10, D50, and D90 of the above fibrous filler respectively mean the fiber length corresponding to the 10% cumulative frequency, the fiber length corresponding to the 50% cumulative frequency, and the fiber length corresponding to the 90% cumulative frequency. Specifically, D10, D50, and D90 can be determined from a fiber length distribution curve in which the fibrous filler is used as the sample, the abscissa represents the fiber length, and the ordinate represents the cumulative frequency. The fiber length distribution curve is a fiber length distribution curve based on the number, obtained by sequential integration in order from a fibrous filler having the shortest fiber length. The fiber length distribution curve can be formed by measuring, for example, the fiber length of 500 or more fibrous fillers that constitute the fibrous filler using an electron microscope or an optical microscope.

Examples of the fibrous filler used in the present invention include a carbon fiber, a metal material represented by a metal fiber and a metal oxide, boron nitride and a metal nitride, silicon carbide and a metal carbide, a metal hydroxide, and a poly-p-phenylenebenzoxazole fiber, and these fibrous fillers may be used singly, or two or more of those described above may be used together. Among those described above as the fibrous filler, a carbon fiber is preferable, and a graphitized carbon fiber is more preferable, from the viewpoint of effectively enhancing thermal conductive properties. A graphitized carbon fiber has a high thermal conductivity in its fiber axis direction because crystal planes of graphite run in the fiber axis direction.

The fibrous filler is a filler having a high aspect ratio and is specifically a filler having an aspect ratio exceeding 2, and the aspect ratio is preferably 5 or more. Setting the aspect ratio to larger than 2 makes it easy to orient the fibrous filler in the thickness direction, so that the thermal conductive properties of the thermally conductive sheet are easily enhanced.

The upper limit of the aspect ratio is not particularly limited, but is 100 in practical use.

The aspect ratio of the fibrous filler means fiber length/diameter of fiber.

The fibrous filler in the thermally conductive sheet is preferably 30 to 500 parts by mass, more preferably 50 to 300 parts by mass, and further preferably 100 to 250 parts by mass based on 100 parts by mass of the matrix. Setting the content of the fibrous filler to these lower limit values or more makes it easy to enhance the thermal conductive properties, and setting the content to the upper limit values or less makes it easy to properly disperse the fibrous filler in the matrix. In addition, the viscosity of the mixed composition, which will be mentioned later, is easily made proper.

As used herein, the range indicated by "to" means a range from the numerical value of the lower limit to the numerical value of the upper limit described before and after "to".

As the fibrous filler, a fibrous filler having a certain average fiber length may be contained singly, or two or more fibrous fillers each having a different average fiber length may be contained. When two or more fibrous fillers each having a different average fiber length are contained, D10, D50, and D90 described above are D10, D50, and D90 of the mixture of two or more fibrous fillers.

The fibrous filler has a thermal conductivity of, though not limited to, generally 60 W/m·K or more, and preferably 400 W/m·K or more along a direction of having anisotropy (that is, major axis direction). The fibrous filler has a thermal conductivity of, for example, 2000 W/m·K or less although the upper limit is not particularly limited. The thermal conductivity can be measured by a laser flash method or a method in accordance with ASTM D5470.

The thermally conductive sheet may contain other fillers other than the fibrous fillers described above, and for example, further preferably comprises a flake-like filler. Containing the flake-like filler can further enhance the effect of reducing the thermal resistance value due to the polishing of the thermally conductive sheet. Examples of the flake-like filler include a carbon material, a metal oxide, boron nitride and a metal nitride, silicon carbide and a metal carbide, and a metal hydroxide, and more specific examples thereof include a flake-like carbon powder, a flake-like silicon carbide powder, a flake-like aluminum nitride powder, a flake-like boron nitride powder, and a flake-like aluminum oxide powder. Among them, at least one selected from the group consisting of a flake-like graphite powder and a flake-like boron nitride powder is preferable, and a flake-like graphite powder is more preferable, from the viewpoint of thermal conductive properties.

When a flake-like filler is contained, the average particle diameter (D50) is preferably 3 to 100 $\mu$m, more preferably 5 to 80 $\mu$m, and further preferably 10 to 50 $\mu$m. Setting the average particle diameter to 3 $\mu$m or more makes it easy for the fillers to come into contact with each other in the thermally conductive sheet, so that heat transmission paths are secured and the thermal conductive properties of the thermally conductive sheet are made good. On the other hand, setting the average particle diameter to 100 $\mu$m or less makes the bulkiness of the thermally conductive sheet low and makes it possible to highly fill the filler in the matrix component.

The average particle diameter of the flake-like filler can be calculated by observing the flake-like filler with a microscope and setting the major axis as the diameter. More specifically, the major axis of arbitrary 500 or more flake-like fillers may be measured using, for example, an electron microscope or an optical microscope, and then D50 may be determined in the same manner as in the fibrous filler.

The aspect ratio of the flake-like filler exceeds 2, and the aspect ratio is preferably 5 or more. Setting the aspect ratio to larger than 2 makes it easy to orient the flake-like filler in the thickness direction, so that the thermal conductive properties of the thermally conductive sheet are easily enhanced. The upper limit of the aspect ratio is not particularly limited, but is 100 in practical use. The aspect ratio of the flake-like filler means the length in the major axis direction/thickness of the flake-like filler.

The flake-like carbon powder is preferably a flake-like graphite powder. The flake-like graphite powder has a high thermal conductivity in its in-plane direction because crystal planes of graphite run in the in-plane direction of the flake plane. Therefore, by allowing flake planes of the flake-like graphite powder to face uniformly in a predetermined direction, the thermal conductivity in a particular direction can be enhanced.

The content of the flake-like filler in the thermally conductive sheet is preferably 1 to 100 parts by mass, more preferably 5 to 50 parts by mass, and still more preferably 10 to 40 parts by mass based on 100 parts by mass of the matrix. When the content of the flake-like filler is these lower limit values or more, the effect of reducing the thermal resistance value due to the polishing of the thermally conductive sheet can be further enhanced, and when the content is these upper limit values or less, the viscosity of the mixed composition, which will be mentioned later, is easily made proper, so that the orientation of the flake-like filler is made good.

As the above-described graphitized carbon materials, such as the graphitized carbon fiber and the flake-like graphite powder, products obtained by graphitizing the following raw materials can be used. Examples thereof include a condensed polycyclic hydrocarbon compound, such as naphthalene, and a condensed heterocyclic compound, such as PAN (polyacrylonitrile) or pitch, and graphitized mesophase pitch having a high degree of graphitization, polyimide, or polybenzazole in particular is preferably used. For example, by using mesophase pitch, the pitch is oriented in the fiber axis direction due to its anisotropy in the spinning step which will be mentioned later, so that a graphitized carbon fiber having excellent thermal conductive properties in the fiber axis direction can be obtained.

The graphitized carbon fiber obtained such that, to raw materials, treatments of spinning, infusibilization, and carbonization are conducted in sequence, and pulverization or cutting is conducted to a predetermined particle diameter, and thereafter graphitization is conducted, or the graphitized carbon fiber such that carbonization is conducted, pulverization or cutting is then conducted, and thereafter graphitization is conducted can be used. When pulverization or cutting is conducted before graphitization, a condensation polymerization and a cyclization reaction progress easily on a surface newly exposed due to pulverization during the graphitization treatment, and therefore a graphitized carbon fiber having thermal conductive properties further improved by enhancing the degree of graphitization can be obtained. When, on the other hand, pulverization is conducted after graphitizing a spun carbon fiber, the carbon fiber after graphitization is rigid and therefore is easily pulverized, so that a carbon fiber powder having a relatively narrow fiber length distribution can be obtained by brief pulverization.

(Non-anisotropic Filler)

The thermally conductive sheet of the present invention preferably further comprises a non-anisotropic filler as the filler. The non-anisotropic filler is a thermally conductive filler contained in the thermally conductive sheet separately from the fibrous filler or the anisotropic filler such as the fibrous filler and the flake-like filler, and is a material which, together with the anisotropic filler, imparts thermal conductive properties to the thermally conductive sheet. By containing the non-anisotropic filler in the thermally conductive sheet, an increase in the viscosity is suppressed, and the dispersibility becomes good in the stage before cured into a sheet. In addition, when, for example, the fiber length is relatively large, it is difficult to increase the contact area between the fillers, but when the non-anisotropic filler fills the space between the anisotropic fillers such as fibrous fillers, heat transmission paths can thereby be formed, so that the thermally conductive sheet having a high thermal conductivity is obtained.

The non-anisotropic filler is a filler whose shape is substantially free of anisotropy, and is a filler that is not oriented in the predetermined direction even in an environment where the fibrous filler is oriented in a predetermined direction, for example, an environment under generation of lines of magnetic force or application of shear force, which will be mentioned later, or the like.

The non-anisotropic filler has an aspect ratio of 2 or less, and preferably 1.5 or less. When the non-anisotropic filler having a low aspect ratio is contained, the filler having thermal conductive properties is thereby properly interposed in the space between the fibrous filler, so that the thermally conductive sheet having a high thermal conductivity is obtained. In addition, by setting the aspect ratio to 2 or less, an increase in the viscosity of the mixed composition which will be mentioned later is prevented, enabling the thermally conductive sheet to be highly filled. The aspect ratio of the anisotropic filler can be determined from major axis/minor axis of the non-anisotropic filler.

Specific examples of the non-anisotropic filler include a metal, a metal oxide, a metal nitride, a metal hydroxide, a carbon material, and an oxide, a nitride, and a carbide other than the metal oxide, the metal nitride, and a metal carbide. Examples of the shape of the non-anisotropic filler include a polygonal, a spherical shape, and an indefinite-form powder. In the non-anisotropic filler, examples of the metal include aluminum, copper, and nickel, examples of the metal oxide include aluminum oxide, magnesium oxide, and zinc oxide, and examples of the metal nitride include aluminum nitride. Examples of the metal hydroxide include aluminum hydroxide. Furthermore, examples of the carbon material include spheroidal graphite. Examples of the oxide, the nitride, and the carbide other than the metal oxide, the metal nitride, and the metal carbide include quartz, boron nitride, and silicon carbide.

Among these described above, the non-anisotropic filler is preferably selected from the group consisting of aluminum oxide, aluminum, zinc oxide, boron nitride, and aluminum nitride, aluminum oxide in particular is preferable from the viewpoint of filling properties and thermal conductivity, and alumina is more preferable.

As the non-anisotropic filler, those described above may be used singly, or two or more of those described above may be used together.

The average particle diameter (D50) of the non-anisotropic filler is preferably 0.1 to 50 $\mu$m, more preferably 0.3 to 35 $\mu$m, and still more preferably 1 to 15 $\mu$m. By setting the average particle diameter to 50 $\mu$m or less, a defect such as disturbing the orientation of the fibrous filler, or the like is made unlikely to occur. By setting the average particle diameter to 0.1 $\mu$m or more, the specific surface area of the non-anisotropic filler is not made larger than needed, and the viscosity of the mixed composition becomes difficult to increase even when a large amount of the non-anisotropic filler is blended and making it easy to highly fill the mixed composition with the non-anisotropic filler.

With respect to the non-anisotropic filler, for example, at least two non-anisotropic fillers having a different average particle diameter each other may be used as the non-anisotropic filler.

The average particle diameter of the non-anisotropic filler can be measured by observation with an electron microscope or the like. More specifically, the particle diameters of arbitrary 500 or more non-anisotropic fillers may be measured using, for example, an electron microscope or an optical microscope, and then D50 may be determined in the same manner as in the fibrous filler.

The content of the non-anisotropic filler is preferably in a range of 100 to 800 parts by mass, more preferably in a range of 150 to 600 parts by mass, and further preferably 180 to 400 parts by mass based on 100 parts by mass of the matrix.

By setting the content of the non-anisotropic filler to 100 parts by mass or more, the amount of the non-anisotropic filler interposed in the space between the fibrous filler is made sufficient, and the thermal conductive properties become good. On the other hand, by setting the content to 800 parts by mass or less, an effect of enhancing the thermal conductive properties corresponding to the content can be obtained.

(Matrix)

The thermally conductive sheet comprises a matrix formed of an organic polymer. The matrix is an organic polymer, such as an elastomer or a rubber, and a product formed by curing a polymer composition (curable polymer composition) in a liquid form, the polymer composition constituted by a mixed system such as the one comprising a base agent and a curing agent, may preferably be used. For example, the curable polymer composition may be a composition composed of an uncrosslinked rubber and a crosslinking agent, or a composition comprising: a monomer, a prepolymer, or the like; and a curing agent or the like. The curing reaction may be normal-temperature curing or heat curing.

Examples of the matrix which is formed from the curable polymer composition include silicone rubber. In the case of silicone rubber, addition reaction-curable type silicone is preferably used as the matrix (curable polymer composition). More specifically, a curable polymer composition comprising alkenyl group-containing organopolysiloxane and hydrogen organopolysiloxane may be used as the curable polymer composition.

Various synthetic rubbers other than the above-described rubber can be used as the rubber, and specific examples thereof include acrylic rubber, nitrile rubber, isoprene rubber, urethane rubber, ethylene propylene rubber, styrene/butadiene rubber, butadiene rubber, fluororubber, and butyl rubber. When any of these rubbers is used, the synthetic rubber may be crosslinked or left uncrosslinked (that is, uncured) in the thermally conductive sheet. Uncrosslinked rubber is used mainly in flow orientation.

When the rubber is crosslinked (that is, cured), the matrix may be, as described above, a product obtained by curing a curable polymer composition composed of an uncrosslinked rubber which is any of these synthetic rubbers, and a crosslinking agent.

As the elastomer, a thermoplastic elastomer, such as a polyester-based thermoplastic elastomer or a polyurethane-based thermoplastic elastomer, or a heat-curable type elastomer which is formed by curing a polymer composition in a liquid form of a mixed system composed of a base agent and a curing agent can be used. Examples of the elastomer include a polyurethane-based elastomer which is formed by curing a polymer composition comprising: a polymer having a hydroxy group; and isocyanate.

Among those described above, silicone rubber, or particularly addition reaction-curable type silicone is preferably used from the viewpoint that, for example, the matrix after curing is particularly soft and filling properties of the fibrous filler, and the flake-like filler and non-anisotropic filler that are blended as necessary are good.

The polymer composition for forming the matrix may be a polymer composition composed of a polymer compound singly, or may be a polymer composition composed of a polymer compound and a plasticizer. The plasticizer is suitably used when a synthetic rubber is used, and when the plasticizer is contained, the flexibility of the uncrosslinked polymer matrix can thereby be enhanced.

The content of the matrix, when expressed by a filling ratio on a volume basis (volume filling ratio), is preferably 20 to 50% by volume, and more preferably 25 to 45% by volume based on the total amount of the thermally conductive sheet.

The content of the matrix is preferably 10 to 40% by mass, and more preferably 15 to 35% by mass based on the total amount of the thermally conductive sheet.

(Additive)

In the present invention, a coupling agent may be used as an additive. The coupling agent may be blended in the mixed composition, which will be mentioned later, and the blended coupling agent may be volatilized during the production of the thermally conductive sheet. The coupling agent may be partially volatilized, and in this case, the remaining coupling agent may be contained in the thermally conductive sheet, or the whole coupling agent may be volatilized. By blending the coupling agent in the mixed composition, which will be mentioned later, enables the dispersibility of the filler such as the fibrous filler in the organic polymer is improved and the viscosity of the mixed composition is reduced, so that it becomes easy to reduce the thermal resistance value of the thermally conductive sheet.

Examples of the coupling agent include a silane coupling agent. Examples of the silane coupling agent include various alkoxysilane compounds such as alkylalkoxysilane.

The amount of the coupling agent blended in the mixed composition, which will be mentioned later, is, for example, 1 to 50 parts by mass, and preferably 5 to 40 parts by mass based on 100 parts by mass of the polymer composition.

In the thermally conductive sheet, various additives may further be blended in the matrix in a range where the function as the thermally conductive sheet is not impaired. Examples of the additive include at least one or more selected from a dispersant, a pressure-sensitive adhesive, a flame retardant, an antioxidant, a coloring agent, an anti-settling agent, and the like. When the curable polymer composition is subjected to be crosslinked, cured, or the like, as described above, a crosslinking accelerator, a curing accelerator, or the like that accelerates crosslinking or curing may be blended as an additive.

(Thermal Resistance Value)

The thermally conductive sheet of the present invention preferably has a thermal resistance value of $0.25°C \cdot cm^2/W$ or less, more preferably $0.2°C \cdot cm^2/W$ or less, and further preferably $0.16°C \cdot cm^2/W$ or less. The thermal resistance value being the above upper limit value or less improves the efficiency of the heat transmission from a heating element to a heat-dissipating element through the thermally conductive sheet, so that excellent thermal conductive properties can be obtained. In the present invention, the lower the thermal resistance value, the more preferable it is, and the thermal resistance value may be $0°C \cdot cm^2/W$ or more, and is for example, $0.01°C \cdot cm^2/W$ or more in practical use, and preferably $0.05°C \cdot cm^2/W$ or more.

The thermal resistance value can be obtained by the measurement method described in Examples.

(E hardness)

The thermally conductive sheet of the present invention preferably has a type E hardness (hereinafter, also referred to as "E hardness") specified in JIS K6253 of 10 to 80, more preferably 20 to 70, and further preferably 30 to 65. The E hardness being the above lower limit value or more makes it easy to polish the thermally conductive sheet in the step (B), which will be mentioned later, and even when the thermally conductive sheet is significantly thin, a certain elastic force is imparted. In addition, the E hardness being the above upper limit value or less imparts certain flexibility to the thermally conductive sheet.

In the thermally conductive sheet, at least one surface is preferably a sliced surface. When at least one surface is a sliced surface, the thermal resistance value can be effectively made low. One surface of the thermally conductive sheet may be a sliced surface, or both surfaces thereof may be sliced surfaces. The sliced surface refers to a surface formed by cutting with a shearing blade or a laser, or the like as described below.

In the thermally conductive sheet, at least one surface is preferably a polished surface.

When at least one surface of the thermally conductive sheet is a polished surface, the thermal resistance value can be more effectively made low. One surface of the thermally conductive sheet may be a polished surface, or both surfaces thereof may be polished surfaces. The polished surface refers to the surface that has been polished by sandpaper or the like as described below.

At least one surface of the thermally conductive sheet is preferably both a sliced surface and a polished surface, and both surfaces thereof are more preferably both sliced surfaces and polished surfaces.

[Method for Producing Thermally Conductive Sheet]

The thermally conductive sheet of the present invention can be produced, for example, by a method comprising the following steps (A) and (B).

Step (A): a step of obtaining an oriented formed body such that a fibrous filler is oriented along one direction
Step (B): a step of cutting the oriented formed body into a sheet-like form to obtain a sheet-like formed body

In addition, the present production method preferably comprises the following step (C). Step (C): a step of polishing a surface of the sheet-like formed body
Hereinafter, each step will be described in more detail.

<Step (A)>

In the step (A), for example, an oriented formed body is formed from a mixed composition comprising: a polymer composition to be a raw material for a matrix; the fibrous filler; and a filler other than the fibrous filler (for example, a flake-like filler or a non-anisotropic filler) and other additives such as a coupling agent, which are blended as necessary. The mixed composition is preferably a composition that is cured into an oriented formed body. The oriented formed body is such that the fibrous filler is oriented along one direction to be a thickness direction in the thermally conductive sheet. More specifically, the oriented formed body can be obtained by a production method by magnetic field orientation or a production method by flow orientation, but among these, the production method by magnetic field orientation is preferable.
The details of the fibrous filler, the flake-like filler, and the non-anisotropic filler that are used as raw materials in the present production method are as described above, and D10, D50, D90, the aspect ratio, the average particle diameter and the like may also be as described above. However, since the fibrous filler may be cut into short pieces during the production process, D10, D50, and D90 thereof are preferably designed to be longer than those described above. For example, D50 of the fibrous filler that is used as a raw material is, for example, less than 140 $\mu$m, preferably less than 100 $\mu$m, more preferably 99.5 $\mu$m or less, and further preferably 90 $\mu$m or less, and preferably 5 $\mu$m or more, more preferably 40 $\mu$m or more, and further preferably 55 $\mu$m or more.
Further, as for the fibrous filler, a fibrous filler having a ratio (D50/T) of the average fiber length D50 to the thickness of the thermally conductive sheet (T) to be obtained of less than 0.58 may be used as the raw material, and the ratio may be, for example, about less than 0.70, and is preferably 0.67 or less. The lower limit of D50/T is not particularly limited, but may be, for example, 0.20 or more, and is preferably 0.40 or more.

(Production Method by Magnetic Field Orientation)

In the production method by magnetic field orientation, the mixed composition comprising: a polymer composition in a liquid form to be a matrix after cured; the fibrous filler; and other fillers, additives, and the like that are blended as necessary is injected inside a casting container or the like, and is then placed in a magnetic field to orient the fibrous filler and the flake-like filler that is blended as necessary along the magnetic field, and the polymer composition is thereafter cured, thereby obtaining an oriented formed body. The oriented formed body is preferably formed into a block-like form. Further, the polymer composition may contain a plasticizer.
A release film may be disposed at a portion which is to be in contact with the mixed composition inside the die. As the release film, for example, a resin film having good releasability, or a resin film such that one surface is release-treated with a release agent or the like is used. Using a release film makes it easy to release the oriented formed body from the die.
The viscosity of the mixed composition which is used in the production method by magnetic field orientation is preferably 10 to 300 Pa·s in order to subject the anisotropic filler to magnetic field orientation. By setting the viscosity to 10 Pa·s or more, each filler is made unlikely to settle. By setting the viscosity to 300 Pa·s or less, the fluidity is made good, the fibrous filler and the flake-like filler that is blended as necessary are oriented properly in the magnetic field, and a defect such as taking too much time for orientation does not occur.
The viscosity refers to viscosity measured using a rotational viscometer (Brookfield viscometer DV-E, Spindle SC4-14) at a rotational speed of 10 rpm at 25°C.
However, when a filler which are unlikely to settle is used, or an additive, such as an anti-settling agent, is combined, the viscosity of the mixed composition may be set to less than 10 Pa·s.
Examples of a source for generating lines of magnetic force, the source for applying the lines of magnetic force, in the production method by magnetic field orientation include a superconducting magnet, a permanent magnet, and an electromagnet, and a superconducting magnet is preferable from the viewpoint that a magnetic field with a high magnetic flux density can be generated. The magnetic flux density of the magnetic field which is generated from these sources for generating lines of magnetic force is preferably 1 to 30 tesla. Setting the magnetic flux density to 1 tesla or more enables a fibrous filler to be oriented easily. Setting the magnetic flux density to 30 tesla or less enables practical production. Curing of the polymer composition may be conducted by heating, and may be conducted at a temperature of, for example, about 50 to about 150°C. The heating time is, for example, about 10 minutes to about 3 hours.

(Production Method by Flow Orientation)

In the production method by flow orientation, shear force may be applied to the mixed composition to produce a preliminary sheet such that the fibrous filler and a flake-like filler that is blended as necessary are oriented in the plane direction, a plurality of the preliminary sheets may be laminated to produce a laminated block, and the laminated block may be used as the oriented formed body.

More specifically, in the production method by flow orientation, the fibrous filler, and a flake-like filler and a non-anisotropic filler that are blended as necessary, and various additives are first mixed with the polymer composition to stir a resultant mixture, thereby preparing a mixed composition in which mixed solid substances are uniformly dispersed. The polymer compound which is used for the polymer composition may be a polymer compound comprising a polymer compound in a liquid form at normal temperature (23°C) or may be a polymer compound comprising a polymer compound in a solid form at normal temperature. Further, the polymer composition may comprise a plasticizer.

The mixed composition has a relatively high viscosity such that shear force is applied when the mixed composition is stretched into a sheet-like form, and specifically, the viscosity of the mixed composition is preferably 3 to 500 Pa·s. A solvent is preferably blended in the mixed composition in order to obtain the viscosity.

Next, the mixed composition is formed into a sheet-like form (preliminary sheet) by stretching flatly while shear force is given to the mixed composition. By applying the shear force, the fibrous filler and the flake-like filler that is blended as necessary can be oriented in the shear direction. With respect to means for forming the sheet, a base film may be coated with the mixed composition, for example, with an applicator for application, such as a bar coater or a doctor blade, or by extrusion forming or ejection from a nozzle, and thereafter, drying may be conducted or the mixed composition may be semi-cured as necessary. The thickness of the preliminary sheet is preferably set to about 50 to about 5000 $\mu$m. In the preliminary sheet, the fibrous filler and the flake-like filler that is blended as necessary are oriented in a direction along the plane direction of the sheet.

Subsequently, a plurality of the preliminary sheets may be stacked and laminated in such a way that the orientation directions are the same, and thereafter the preliminary sheets may be allowed to adhere to one another with a heat press or the like while the mixed composition is cured as necessary by heating, irradiation with an ultraviolet ray, or the like to form a laminated block, and the laminated block may be used as the oriented formed body.

<Step (B)>

In the step (B), the oriented formed body obtained in the step (A) is cut by slicing or the like perpendicularly to a direction of the orientation of the fibrous filler, thereby obtaining a sheet-like formed body. The slicing may be conducted with, for example, a shearing blade or laser. In the sheet-like formed body, a part of the fibrous filler may be exposed from the matrix on each surface which is a section by cutting, such as slicing. Almost all the exposed fibrous fillers are oriented in the thickness direction without falling down.

In the step (B), along with cutting the oriented formed body by slicing or the like, the fibrous filler contained in the oriented formed body may be cut in a range not impairing the effect of the present invention.

The sheet-like formed body obtained by slicing in the step (B) may be further heated, the sheet-like formed body may be secondarily cured by heating, and when a coupling agent is blended in the mixed composition, a part of or the whole coupling agent may be volatilized by heating the sheet-like formed body. The heating of the sheet-like formed body is preferably performed before the step (C), which will be mentioned later, and may be performed after the step (C).

The heating of the sheet-like formed body may be performed at, for example, 100 to 200°C, and preferably 120 to 180°C for, for example, 30 minutes to 24 hours, and preferably 1 to 6 hours.

The sheet-like formed body obtained through the above step (B) may be used as the thermally conductive sheet as it is, and is preferably made into a thermally conductive sheet by being polished through the step (C), which will be mentioned later. Polishing makes the surface state of the sheet-like formed body good, so that the thermal resistance value is easily further reduced.

<Step (C)>

The step (C) is a step of polishing a surface of the sheet-like formed body. Polishing the sheet-like formed body can make the sheet surface smooth while a certain amount of the anisotropic filler such as the fibrous filler is exposed on the surface. In addition, the fibrous filler can be brought into, for example, a fallen state. Thus, the surface of the thermally conductive sheet is easily closely adhered to other members, and a certain area or more of the sheet surface is easily brought into a state covered with the fibrous filler, so that the thermal resistance value is easily reduced.

In the step (C), at least one surface of the sheet-like formed body obtained in the step (B) may be polished, and both surfaces of the sheet-like formed body are preferably polished. The polishing of the surface may be conducted using, for example, sandpaper, a polishing film, a polishing cloth, and a polishing belt.

Sandpaper having an average grain diameter (D50) of contained abrasive grains of 0.1 to 100 μm as a characteristic of the sandpaper is preferable, and sand paper more preferably has an average grain diameter of contained abrasive grains of 1 to 60 μm. The particle size of abrasive grains of sandpaper for example is preferably #120 to 20000, preferably #300 to 15000, and more preferably #320 to 4000.

As the polishing method, a method in which, for example, polishing is conducted by allowing sandpaper to abut on the surface of the sheet-like formed body continuously in the same linear direction, polishing is conducted by reciprocating sandpaper on the surface of the thermally conductive sheet within a certain distance, polishing is conducted by rotating sandpaper in the same direction on the surface of the thermally conductive sheet, or polishing is conducted by allowing sandpaper to abut on the surface of the thermally conductive sheet in various directions can be used.

With respect to the extent of polishing, the polishing may be conducted, for example, while the surface state is being observed, but in the case of reciprocation polishing for example, 1 to 300 times of reciprocation is preferable, more preferably 2 to 200 times, and still more preferably 3 to 50 times.

The polishing of the surface of the sheet-like formed body may be performed by being divided into two polishing steps. For example, after the first polishing using sandpaper having a large average grain diameter of abrasive grains, the second polishing may be performed using sandpaper having a smaller average grain diameter of abrasive grains than that in the first polishing.

<Second Embodiment>

Next, a thermally conductive sheet according to the second embodiment of the present invention will be described. Hereinafter, the difference between the thermally conductive sheet according to the second embodiment and the thermally conductive sheet according to the first embodiment will be described.

The thermally conductive sheet according to the second embodiment is a thermally conductive sheet comprising a matrix formed of an organic polymer, and a fibrous filler, wherein the thickness of the thermally conductive sheet is less than 200 μm, the fibrous filler is oriented in the thickness direction of the thermally conductive sheet, and the average fiber length D50 of the fibrous filler contained in the sheet is 5 μm or more and less than 85 μm.

In the present invention, setting the average fiber length D50 to 5 μm or more in a thin thermally conductive sheet as described above can make the thermal conductive properties of the thermally conductive sheet good. Setting the average fiber length D50 to less than 85 μm enables the dropping of the fibrous filler to be suppressed and the thermal resistance value of the thermally conductive sheet to be reduced. From these viewpoints, the average fiber length D50 in the second embodiment is preferably 25 μm or more and 84 μm or less, and more preferably 35 μm or more and 73 μm or less.

When the thickness of the thermally conductive sheet is less than 200 μm and 150 μm or more, the upper limit of the average fiber length D50 is preferably less than 85 μm; when the thickness is less than 150 μm and 125 μm or more, the upper limit of the average fiber length D50 is preferably 75 μm or less; when the thickness of the thermally conductive sheet is less than 125 μm and 100 μm or more, the upper limit of the average fiber length D50 is preferably 60 μm or less; when the thickness of the thermally conductive sheet is less than 100 μm and 75 μm or more, the upper limit of the average fiber length D50 is preferably 50 μm or less; and when the thickness of the thermally conductive sheet is less than 75 μm and 50 μm or more, the upper limit of the average fiber length D50 is preferably 40 μm or less.

The ratio (D50/T) of the average fiber length D50 of the fibrous filler to the thickness of the thermally conductive sheet (T) may be, as in the first embodiment, less than 0.58, but does not need to be less than 0.58. The preferred range of the ratio (D50/T) is the same as above. Other detailed descriptions with respect to the fibrous filler, and detailed descriptions with respect to the filler other than the fibrous filler, matrix, additive, thermal resistance value, E hardness, aspect of the sheet surface, method for producing the thermally conductive sheet, and the like are as described in the above first embodiment, and are thus omitted.

[Use of Thermally Conductive Sheet]

The thermally conductive sheet is used inside an electronic device or the like. Specifically, the thermally conductive sheet is interposed between a heating element and a heat-dissipating element, transfers heat generated at the heating element to the heat-dissipating element by heat conduction, and dissipates heat from the heat-dissipating element. Examples of the heating element herein include various electronic parts, such as CPU, a power amplifier, and a power source such as a battery, which are used inside an electronic device. Examples of the heat-dissipating element include a heat sink, a heat pipe, a heat pump, and a metal housing of an electronic device. The thermally conductive sheet is used in such a way that the surfaces closely adhere to a heating element and a heat-dissipating element, respectively and the thermally conductive sheet is compressed.

Examples

Hereinafter, the present invention will be described with reference to Examples in more detail, but the present invention is not limited at all by these Examples.

The measurement method and evaluation method in the present Example are as follows.

[Average Fiber Length D10, D50, D90]

The average fiber lengths D10, D50, and D90 of the fibrous filler in the thermally conductive sheet were measured as described below. First, the thermally conductive sheet was immersed and dissolved in a silicone dissolving agent (KSR-1, manufactured by Kanto Chemical Co., Inc.). Then, the dissolution solution was subjected to centrifugation to separate a solid component and a liquid. The resulting solid component was further immersed in the silicone dissolving agent and subjected to centrifugation twice, and the resulting solid component was further immersed in solvent naphtha and subjected to centrifugation twice for washing, and thereafter, solvent naphtha was dried to isolate the solid component in a powder form. Here, the solid component contains a fibrous filler and a non-fibrous filler. Then, an observation image (image) was obtained from the resulting isolate using an optical microscope ("VHX-S15" manufactured by KEYENCE CORPORATION), and thereafter, the fiber lengths of individual fibrous fillers of about 500 fibrous fillers were measured with an image analysis software WinROOF (manufactured by MITANI CORPORATION). At this time, fibrous fillers having an aspect ratio of 2 or more were only measured by needle separation with WinROOF. Subsequently, a fiber length distribution curve in which the abscissa represents the fiber length and the ordinate represents the cumulative frequency (based on the number) was obtained. The average fiber lengths D10, D50, and D90 of the fibrous filler were determined from the obtained fiber length distribution curve.

In addition, D50 of the fibrous filler used as the raw material was determined by measuring the fiber lengths of individual fibrous fillers of about 500 fibrous fillers obtained by observing the fibrous filler before being blended in the mixed composition with the optical microscope in the same manner as above. Also, D50 and the aspect ratio of the flake-like filler and the non-anisotropic filler were determined by observing about 500 particles with the optical microscope as above. In Examples, the aspect ratio refers to an average value.

[Initial Thickness]

The thickness (initial thickness) of the thermally conductive sheet before measuring the thermal resistance value was measured using a thickness gage.

[E hardness]

The type E hardness of the thermally conductive sheet was measured based on JIS K 6253, which is a Japanese industrial standard. Specifically, measurement was performed using a type E durometer on the oriented formed bodies prepared in the respective examples.

[Thermal Resistance Value]

The thermal resistance value was measured using a thermal resistance measuring machine as shown in Fig. 1 by the method described below.

Specifically, a test piece S having a size of 30 mm × 30 mm for the present test was prepared for each sample. Each test piece S was attached on a copper block 22 such that a measurement face has a size of 25.4 mm × 25.4 mm and side faces are covered with a thermal insulator 21, and was held between the copper block and an upper copper block 23, and load of 40 psi was applied with a load cell 26. The lower copper block 22 is in contact with a heater 24. The upper copper block 23 is covered with the thermal insulator 21 and is connected to a heat sink 25 with a fan. Subsequently, the heater 24 was heated to 80°C, and 10 minutes later when the temperature would reach an almost stationary state, the temperature of the upper copper block 23 ($\theta_{j0}$), the temperature of the lower copper block 22 ($\theta_{j1}$), and the calorific value of the heater (Q) were measured to determine the thermal resistance value of each sample from the following expression (1). The thickness of the thermally conductive sheet during the measurement of the thermal resistance value was also measured simultaneously with the measurement of the thermal resistance value.

$$\text{Thermal resistance} = (\theta_{j1}-\theta_{j0})/Q ... \text{ Expression (1)}$$

wherein, $\theta_{j1}$ represents the temperature of the lower copper block 22, $\theta_{j0}$ represents the temperature of the upper copper block 23, and Q represents the calorific value.

[Component Used]

The following components were used as the raw materials of the thermally conductive sheet.

(Polymer Composition)

An alkenyl group-containing organopolysiloxane as the base agent (silicone A agent), an addition reaction type organopolysiloxane including a hydrogen organopolysiloxane as the curing agent (silicone B agent)

(Fibrous Filler)

The following fillers were used as the fibrous filler.

Graphitized carbon fiber (1) ... average fiber length (D50) 55.1 $\mu$m, (D10) 32.4 $\mu$m, (D90) 105.9 $\mu$m, thermal conductivity 1200 W/m·K
Graphitized carbon fiber (2) ... average fiber length (D50) 76.7 $\mu$m, (D10) 40.2 $\mu$m, (D90) 127.1 $\mu$m, thermal conductivity 1200 W/m·K
Graphitized carbon fiber (3) ... average fiber length (D50) 82.2 $\mu$m, (D10) 46.3 $\mu$m, (D90) 142.8 $\mu$m, thermal conductivity 1200 W/m·K
Graphitized carbon fiber (4) ... average fiber length (D50) 87.0 $\mu$m, (D10) 44.0 $\mu$m, (D90) 166.7 $\mu$m, thermal conductivity 1200 W/m·K
Graphitized carbon fiber (5) ... average fiber length (D50) 94.9 $\mu$m, (D10) 49.2 $\mu$m, (D90) 176.0 $\mu$m, thermal conductivity 1200 W/m·K
Graphitized carbon fiber (6) ... average fiber length (D50) 99.2 $\mu$m, (D10) 51.4 $\mu$m, (D90) 183.2 $\mu$m, thermal conductivity 1200 W/m·K
Graphitized carbon fiber (7) ... average fiber length (D50) 100.8 $\mu$m, (D10) 55.3 $\mu$m, (D90) 190.3 $\mu$m, thermal conductivity 1200 W/m·K
Graphitized carbon fiber (8) ... average fiber length (D50) 126.2 $\mu$m, (D10) 71.0 $\mu$m, (D90) 253.8 $\mu$m, thermal conductivity 1200 W/m·K

With respect to graphitized carbon fibers (1) to (8), graphitized carbon fibers having a diameter of about 10 $\mu$m were pulverized by adjusting pulverization conditions so that the above average fiber lengths can be obtained.
Each average fiber length of each graphitized carbon fiber in the sheet after forming the sheet is as described in the column of characteristics value in Tables 1 to 10.
Coupling agent .. n-decyltrimethoxysilane
Flake-like graphite powder .. flaky, average particle diameter (D50) 15 $\mu$m, aspect ratio 10, thermal conductivity 550 W/m·K
Aluminum powder .. indefinite-form, average particle diameter (D50) 3 $\mu$m, aspect ratio 1 to 1.5
Aluminum oxide (1) .. polygonal, average particle diameter (D50) 0.5 $\mu$m, aspect ratio 1.0
Aluminum oxide (2) .. spherical, average particle diameter (D50) 3 $\mu$m, aspect ratio 1.0

[Example 1]

A mixed composition was obtained by mixing: the alkenyl group-containing organopolysiloxane and hydrogen organopolysiloxane (100 parts by mass in total) as the polymer composition; 15 parts by mass of the coupling agent; 160 parts by mass of the graphitized carbon fiber (3); 20 parts by mass of the flake-like graphite powder; 243 parts by mass of the aluminum powder; and 30 parts by mass of the aluminum oxide (1) with a planetary mixer at 25°C for 50 minutes.
Subsequently, the mixed composition was injected into a die whose thickness was set in such a way as to be sufficiently larger than that of each thermally conductive sheet, a magnetic field of 8T was applied in the thickness direction to orient the carbon fiber in the thickness direction, and the matrix was thereafter cured by heating at 80°C for 60 minutes,

**EP 4 503 121 A1**

thereby obtaining a block-like oriented formed body.

Next, the block-like oriented formed body was sliced into a sheet-like form having a thickness of about 150 $\mu$m using a shearing blade, thereby obtaining a sheet-like formed body such that the carbon fiber is exposed. Thereafter, the sheet-like formed body was heated at 150°C for 2 hours.

Subsequently, reciprocation polishing was conducted 25 times on the sheet-like formed body with rough sandpaper A (grain size of #800) having an average grain diameter (D50) of abrasive grains of 20 $\mu$m, and thereafter, reciprocation polishing was further conducted 10 times thereon with rough sandpaper B (grain size of #4000) having an average grain diameter (D50) of abrasive grains of 3 $\mu$m.

[Examples 2 to 8, Comparative Examples 1 to 32]

A thermally conductive sheet was prepared in the same manner as in Example 1, except that the composition of the mixed composition was changed to that described in Tables 1 to 8 and the thickness of the resulting thermally conductive sheet was adjusted as in Tables 1 to 8.

[Table 1]

| | | Example 1 | Comparative Example 1 | Example 2 | Comparative Example 3 | Comparative Example 4 |
|---|---|---|---|---|---|---|
| Blend (parts by mass) | Silicone A agent | 91 | 91 | 91 | 91 | 91 |
| | Silicone B agent | 9 | 9 | 9 | 9 | 9 |
| | n-Decyl trimethoxysilane | 15 | 15 | 15 | 15 | 15 |
| | Graphitized carbon fiber (1) D50 = 55.1 $\mu$m | | | | | |
| | Graphitized carbon fiber (2) D50 = 76.7 $\mu$m | | | | | |
| | Graphitized carbon fiber (3) D50 = 82.2 $\mu$m | 160 | 160 | 160 | 160 | 160 |
| | Graphitized carbon fiber (4) D50 = 87.0 $\mu$m | | | | | |
| | Graphitized carbon fiber (5) D50 = 94.9 $\mu$m | | | | | |
| | Graphitized carbon fiber (6) D50 = 99.2 $\mu$m | | | | | |
| | Graphitized carbon fiber (7) D50 = 100.8 $\mu$m | | | | | |
| | Graphitized carbon fiber (8) D50 = 126.2 $\mu$m | | | | | |
| | Flake-like graphite D50 = 15 $\mu$m, aspect ratio 10, 550 W/m·K | 20 | 20 | 20 | 20 | 20 |

14

(continued)

| | | Example 1 | Comparative Example 1 | Example 2 | Comparative Example 3 | Comparative Example 4 |
|---|---|---|---|---|---|---|
| | Aluminum powder (Spherical, D50 = 3 μm, Aspect ratio 1 to 1.5) | 243 | 243 | 243 | 243 | 243 |
| | Aluminum oxide (1) (Polygonal, D50 = 0.5 μm, aspect ratio 1) | 30 | 30 | 30 | 30 | 30 |
| | Aluminum oxide (2) (Spherical, D50 = 3 μm, aspect ratio 1) | | | | | |
| Characteristics value | Average fiber length D10 (μm) | 46.4 | 45.3 | 45.5 | 46.5 | 46.1 |
| | Average fiber length D50 (μm) | 68.8 | 70.9 | 69.2 | 69.0 | 66.5 |
| | Average fiber length D90 (μm) | 110.5 | 123.9 | 119.9 | 116.5 | 94.8 |
| | Initial thickness of thermally conductive sheet (mm) | 0.15 | 0.50 | 0.30 | 0.20 | 0.10 |
| | Hardness (E hardness) of thermally conductive sheet | 48 | 48 | 48 | 48 | 48 |
| Evaluation item | Thermal resistance value (°C·cm$^2$/W, 40 psi) | 0.109 | 0.229 | 0.165 | 0.119 | 0.115 |
| | Thickness in measurement of thermal resistance value (mm) | 0.089 | 0.345 | 0.209 | 0.150 | 0.059 |
| | D50 (mm)/Initial thickness of thermally conductive sheet (mm) | 0.46 | 0.14 | 0.23 | 0.35 | 0.67 |

[Table 2]

| | | Example 2 | Comparative Example 5 | Comparative Example 6 | Comparative Example 7 | Comparative Example 8 |
|---|---|---|---|---|---|---|
| | Silicone A agent | 91 | 91 | 91 | 91 | 91 |
| | Silicone B agent | 9 | 9 | 9 | 9 | 9 |
| | n-Decyl trimethoxysilane | 15 | 15 | 15 | 15 | 15 |

(continued)

| | | Example 2 | Comparative Example 5 | Comparative Example 6 | Comparative Example 7 | Comparative Example 8 |
|---|---|---|---|---|---|---|
| Blend (parts by mass) | Graphitized carbon fiber (1) D50 = 55.1 $\mu$m | | | | | |
| | Graphitized carbon fiber (2) D50 = 76.7 $\mu$m | | | | | |
| | Graphitized carbon fiber (3) D50 = 82.2 $\mu$m | 130 | 130 | 130 | 130 | 130 |
| | Graphitized carbon fiber (4) D50 = 87.0 $\mu$m | | | | | |
| | Graphitized carbon fiber (5) D50 = 94.9 $\mu$m | | | | | |
| | Graphitized carbon fiber (6) D50 = 99.2 $\mu$m | | | | | |
| | Graphitized carbon fiber (7) D50 = 100.8 $\mu$m | | | | | |
| | Graphitized carbon fiber (8) D50 = 126.2 $\mu$m | | | | | |
| | Flake-like graphite D50 = 15 $\mu$m, aspect ratio 10, 550 W/m·K | 20 | 20 | 20 | 20 | 20 |
| | Aluminum powder (Spherical, D50 = 3 $\mu$m, Aspect ratio 1 to 1.5) | 243 | 243 | 243 | 243 | 243 |
| | Aluminum oxide (1) (Polygonal, D50 = 0.5 $\mu$m, aspect ratio 1) | 30 | 30 | 30 | 30 | 30 |
| | Aluminum oxide (2) (Spherical, D50 = 3 $\mu$m, aspect ratio 1) | | | | | |

(continued)

| | | Example 2 | Comparative Example 5 | Comparative Example 6 | Comparative Example 7 | Comparative Example 8 |
|---|---|---|---|---|---|---|
| Characteristics value | Average fiber length D10 ($\mu$m) | 45.2 | 45.5 | 45.3 | 45.2 | 44.8 |
| | Average fiber length D50 ($\mu$m) | 72.3 | 75.3 | 74.6 | 74.1 | 70.2 |
| | Average fiber length D90 ($\mu$m) | 113.2 | 130.5 | 125.5 | 117.8 | 97.2 |
| | Initial thickness of thermally conductive sheet (mm) | 0.15 | 0.50 | 0.30 | 0.20 | 0.10 |
| | Hardness (E hardness) of thermally conductive sheet | 45 | 45 | 45 | 45 | 45 |
| Evaluation item | Thermal resistance value (°C·cm$^2$/W, 40 psi) | 0.112 | 0.212 | 0.154 | 0.119 | 0.118 |
| | Thickness in measurement of thermal resistance value (mm) | 0.087 | 0.431 | 0.259 | 0.168 | 0.057 |
| | D50 (mm)/Initial thickness of thermally conductive sheet (mm) | 0.48 | 0.15 | 0.25 | 0.37 | 0.70 |

[Table 3]

| | | Example 3 | Comparative Example 9 | Comparative Example 10 | Comparative Example 11 | Comparative Example 12 |
|---|---|---|---|---|---|---|
| | Silicone A agent | 91 | 91 | 91 | 91 | 91 |
| | Silicone B agent | 9 | 9 | 9 | 9 | 9 |
| | n-Decyl trimethoxysilane | 15 | 15 | 15 | 15 | 15 |
| | Graphitized carbon fiber (1) D50 = 55.1 $\mu$m | | | | | |
| | Graphitized carbon fiber (2) D50 = 76.7 $\mu$m | | | | | |
| | Graphitized carbon fiber (3) D50 = 82.2 $\mu$m | | | | | |
| | Graphitized carbon fiber (4) D50 = 87.0 $\mu$m | 160 | 160 | 160 | 160 | 160 |

(continued)

| | | Example 3 | Comparative Example 9 | Comparative Example 10 | Comparative Example 11 | Comparative Example 12 |
|---|---|---|---|---|---|---|
| Blend (parts by mass) | Graphitized carbon fiber (5) D50 = 94.9 μm | | | | | |
| | Graphitized carbon fiber (6) D50 = 99.2 μm | | | | | |
| | Graphitized carbon fiber (7) D50 = 100.8 μm | | | | | |
| | Graphitized carbon fiber (8) D50 = 126.2 μm | | | | | |
| | Flake-like graphite D50 = 15 μm, aspect ratio 10, 550 W/m·K | 20 | 20 | 20 | 20 | 20 |
| | Aluminum powder (Spherical, D50 = 3 μm, Aspect ratio 1 to 1.5) | 243 | 243 | 243 | 243 | 243 |
| | Aluminum oxide (1) (Polygonal, D50 = 0.5 μm, aspect ratio 1) | 30 | 30 | 30 | 30 | 30 |
| | Aluminum oxide (2) (Spherical, D50 = 3 μm, aspect ratio 1) | | | | | |
| Characteristics value | Average fiber length D10 (μm) | 43.5 | 43.8 | 43.7 | 43.6 | 43.2 |
| | Average fiber length D50 (μm) | 72.5 | 75.2 | 73.9 | 73.5 | 70.3 |
| | Average fiber length D90 (μm) | 121.1 | 145.2 | 139.5 | 131.1 | 95.2 |
| | Initial thickness of thermally conductive sheet (mm) | 0.15 | 0.50 | 0.30 | 0.20 | 0.10 |
| | Hardness (E hardness) of thermally conductive sheet | 57 | 57 | 57 | 57 | 57 |

(continued)

| | | Example 3 | Comparative Example 9 | Comparative Example 10 | Comparative Example 11 | Comparative Example 12 |
|---|---|---|---|---|---|---|
| Evaluation item | Thermal resistance value (°C·cm²/W, 40 psi) | 0.104 | 0.185 | 0.138 | 0.115 | 0.113 |
| | Thickness in measurement of thermal resistance value (mm) | 0.098 | 0.385 | 0.237 | 0.152 | 0.056 |
| | D50 (mm)/Initial thickness of thermally conductive sheet (mm) | 0.48 | 0.15 | 0.25 | 0.37 | 0.70 |

[Table 4]

| | | Example 4 | Comparative Example 13 | Comparative Example 14 | Comparative Example 15 | Comparative Example 16 |
|---|---|---|---|---|---|---|
| Blend (parts by mass) | Silicone A agent | 91 | 91 | 91 | 91 | 91 |
| | Silicone B agent | 9 | 9 | 9 | 9 | 9 |
| | n-Decyl trimethoxysilane | 15 | 15 | 15 | 15 | 15 |
| | Graphitized carbon fiber (1) D50 = 55.1 μm | | | | | |
| | Graphitized carbon fiber (2) D50 = 76.7 μm | 160 | 160 | 160 | 160 | 160 |
| | Graphitized carbon fiber (3) D50 = 82.2 μm | | | | | |
| | Graphitized carbon fiber (4) D50 = 87.0 μm | | | | | |
| | Graphitized carbon fiber (5) D50 = 94.9 μm | | | | | |
| | Graphitized carbon fiber (6) D50 = 99.2 μm | | | | | |
| | Graphitized carbon fiber (7) D50 = 100.8 μm | | | | | |
| | Graphitized carbon fiber (8) D50 = 126.2 μm | | | | | |

(continued)

| | | Example 4 | Comparative Example 13 | Comparative Example 14 | Comparative Example 15 | Comparative Example 16 |
|---|---|---|---|---|---|---|
| | Flake-like graphite D50 = 15 μm, aspect ratio 10, 550 W/m·K | 20 | 20 | 20 | 20 | 20 |
| | Aluminum powder (Spherical, D50 = 3 μm, Aspect ratio 1 to 1.5) | 243 | 243 | 243 | 243 | 243 |
| | Aluminum oxide (1) (Polygonal, D50 = 0.5 μm, aspect ratio 1) | 30 | 30 | 30 | 30 | 30 |
| | Aluminum oxide (2) (Spherical, D50 = 3 μm, aspect ratio 1) | | | | | |
| Characteristics value | Average fiber length D10 (μm) | 40.2 | 39.9 | 40.4 | 39.8 | 38.9 |
| | Average fiber length D50 (μm) | 63.0 | 66.4 | 65.7 | 63.9 | 61.4 |
| | Average fiber length D90 (μm) | 101.8 | 111.5 | 107.3 | 105.6 | 93.5 |
| | Initial thickness of thermally conductive sheet (mm) | 0.15 | 0.50 | 0.30 | 0.20 | 0.10 |
| | Hardness (E hardness) of thermally conductive sheet | 54 | 54 | 54 | 54 | 54 |
| Evaluation item | Thermal resistance value (°C·cm$^2$/W, 40 psi) | 0.114 | 0.205 | 0.145 | 0.123 | 0.12 |
| | Thickness in measurement of thermal resistance value (mm) | 0.098 | 0.392 | 0.237 | 0.152 | 0.056 |
| | D50 (mm)/Initial thickness of thermally conductive sheet (mm) | 0.42 | 0.13 | 0.22 | 0.32 | 0.61 |

[Table 5]

| | | Example 5 | Comparative Example 17 | Comparative Example 18 | Comparative Example 19 | Comparative Example 20 |
|---|---|---|---|---|---|---|
| | Silicone A agent | 91 | 91 | 91 | 91 | 91 |
| | Silicone B agent | 9 | 9 | 9 | 9 | 9 |

(continued)

| | | Example 5 | Comparative Example 17 | Comparative Example 18 | Comparative Example 19 | Comparative Example 20 |
|---|---|---|---|---|---|---|
| Blend (parts by mass) | n-Decyl tri-methoxysilane | 15 | 15 | 15 | 15 | 15 |
| | Graphitized carbon fiber (1) D50 = 55.1 μm | | | | | |
| | Graphitized carbon fiber (2) D50 = 76.7 μm | | | | | |
| | Graphitized carbon fiber (3) D50 = 82.2 μm | | | | | |
| | Graphitized carbon fiber (4) D50 = 87.0 μm | | | | | |
| | Graphitized carbon fiber (5) D50 = 94.9 μm | 160 | 160 | 160 | 160 | 160 |
| | Graphitized carbon fiber (6) D50 = 99.2 μm | | | | | |
| | Graphitized carbon fiber (7) D50 = 100.8 μm | | | | | |
| | Graphitized carbon fiber (8) D50 = 126.2 μm | | | | | |
| | Flake-like graphite D50 = 15 μm, aspect ratio 10, 550 W/m·K | 20 | 20 | 20 | 20 | 20 |
| | Aluminum powder (Spherical, D50 = 3 μm, Aspect ratio 1 to 1.5) | 243 | 243 | 243 | 243 | 243 |
| | Aluminum oxide (1) (Polygonal, D50 = 0.5 μm, aspect ratio 1) | 30 | 30 | 30 | 30 | 30 |
| | Aluminum oxide (2) (Spherical, D50 = 3 μm, aspect ratio 1) | | | | | |

(continued)

| | | Example 5 | Comparative Example 17 | Comparative Example 18 | Comparative Example 19 | Comparative Example 20 |
|---|---|---|---|---|---|---|
| Characteristics value | Average fiber length D10 (μm) | 48.6 | 48.5 | 48.3 | 48.1 | 48.8 |
| | Average fiber length D50 (μm) | 79.5 | 81.7 | 79.9 | 79.7 | 76.9 |
| | Average fiber length D90 (μm) | 127.0 | 152.6 | 146.9 | 137.8 | 95.8 |
| | Initial thickness of thermally conductive sheet (mm) | 0.15 | 0.50 | 0.30 | 0.20 | 0.10 |
| | Hardness (E hardness) of thermally conductive sheet | 58 | 58 | 58 | 58 | 58 |
| Evaluation item | Thermal resistance value (°C·cm$^2$/W, 40 psi) | 0.108 | 0.193 | 0.133 | 0.113 | 0.115 |
| | Thickness in measurement of thermal resistance value (mm) | 0.102 | 0.391 | 0.242 | 0.161 | 0.063 |
| | D50 (mm)/Initial thickness of thermally conductive sheet (mm) | 0.53 | 0.16 | 0.27 | 0.40 | 0.77 |

[Table 6]

| | | Example 6 | Comparative Example 21 | Comparative Example 22 | Comparative Example 23 | Comparative Example 24 |
|---|---|---|---|---|---|---|
| | Silicone A agent | 91 | 91 | 91 | 91 | 91 |
| | Silicone B agent | 9 | 9 | 9 | 9 | 9 |
| | n-Decyl trimethoxysilane | 15 | 15 | 15 | 15 | 15 |
| | Graphitized carbon fiber (1) D50 = 55.1 μm | | | | | |
| | Graphitized carbon fiber (2) D50 = 76.7 μm | | | | | |
| | Graphitized carbon fiber (3) D50 = 82.2 μm | | | | | |
| | Graphitized carbon fiber (4) D50 = 87.0 μm | | | | | |

(continued)

| | | Example 6 | Comparative Example 21 | Comparative Example 22 | Comparative Example 23 | Comparative Example 24 |
|---|---|---|---|---|---|---|
| Blend (parts by mass) | Graphitized carbon fiber (5) D50 = 94.9 $\mu$m | | | | | |
| | Graphitized carbon fiber (6) D50 = 99.2 $\mu$m | 160 | 160 | 160 | 160 | 160 |
| | Graphitized carbon fiber (7) D50 = 100.8 $\mu$m | | | | | |
| | Graphitized carbon fiber (8) D50 = 126.2 $\mu$m | | | | | |
| | Flake-like graphite D50 = 15 $\mu$m, aspect ratio 10, 550 W/m·K | 20 | 20 | 20 | 20 | 20 |
| | Aluminum powder (Spherical, D50 = 3 $\mu$m, Aspect ratio 1 to 1.5) | 243 | 243 | 243 | 243 | 243 |
| | Aluminum oxide (1) (Polygonal, D50 = 0.5 $\mu$m, aspect ratio 1) | 30 | 30 | 30 | 30 | 30 |
| | Aluminum oxide (2) (Spherical, D50 = 3 $\mu$m, aspect ratio 1) | | | | | |
| Characteristics value | Average fiber length D10 ($\mu$m) | 50.3 | 50.4 | 51.4 | 50.3 | 50.4 |
| | Average fiber length D50 ($\mu$m) | 83.5 | 85.8 | 83.4 | 84.0 | 79.2 |
| | Average fiber length D90 ($\mu$m) | 131.8 | 159.9 | 152.7 | 143.4 | 96.8 |
| | Initial thickness of thermally conductive sheet (mm) | 0.15 | 0.50 | 0.30 | 0.20 | 0.10 |
| | Hardness (E hardness) of thermally conductive sheet | 59 | 59 | 59 | 59 | 59 |

(continued)

| | | Example 6 | Comparative Example 21 | Comparative Example 22 | Comparative Example 23 | Comparative Example 24 |
|---|---|---|---|---|---|---|
| Evaluation item | Thermal resistance value (°C·cm$^2$/W, 40 psi) | 0.110 | 0.177 | 0.131 | 0.112 | 0.117 |
| | Thickness in measurement of thermal resistance value (mm) | 0.104 | 0.389 | 0.243 | 0.161 | 0.064 |
| | D50 (mm)/Initial thickness of thermally conductive sheet (mm) | 0.56 | 0.17 | 0.28 | 0.42 | 0.79 |

[Table 7]

| | | Example 7 | Example 8 | Comparative Example 25 | Comparative Example 26 | Comparative Example 27 |
|---|---|---|---|---|---|---|
| Blend (parts by mass) | Silicone A agent | 91 | 91 | 91 | 91 | 91 |
| | Silicone B agent | 9 | 9 | 9 | 9 | 9 |
| | n-Decyl trimethoxysilane | 15 | 15 | 15 | 15 | 15 |
| | Graphitized carbon fiber (1) D50 = 55.1 μm | 160 | 160 | 160 | 160 | 160 |
| | Graphitized carbon fiber (2) D50 = 76.7 μm | | | | | |
| | Graphitized carbon fiber (3) D50 = 82.2 μm | | | | | |
| | Graphitized carbon fiber (4) D50 = 87.0 μm | | | | | |
| | Graphitized carbon fiber (5) D50 = 94.9 μm | | | | | |
| | Graphitized carbon fiber (6) D50 = 99.2 μm | | | | | |
| | Graphitized carbon fiber (7) D50 = 100.8 μm | | | | | |
| | Graphitized carbon fiber (8) D50 = 126.2 μm | | | | | |

(continued)

|  |  | Example 7 | Example 8 | Comparative Example 25 | Comparative Example 26 | Comparative Example 27 |
|---|---|---|---|---|---|---|
| | Flake-like graphite D50 = 15 μm, aspect ratio 10, 550 W/m·K | 20 | 20 | 20 | 20 | 20 |
| | Aluminum powder (Spherical, D50 = 3 μm, Aspect ratio 1 to 1.5) | 243 | 243 | 243 | 243 | 243 |
| | Aluminum oxide (1) (Polygonal, D50 = 0.5 μm, aspect ratio 1) | 30 | 30 | 30 | 30 | 30 |
| | Aluminum oxide (2) (Spherical, D50 = 3 μm, aspect ratio 1) | | | | | |
| Characteristics value | Average fiber length D10 (μm) | 31.4 | 31.5 | 31.9 | 32.1 | 32.3 |
| | Average fiber length D50 (μm) | 51.8 | 51.3 | 52.4 | 52.8 | 51.6 |
| | Average fiber length D90 (μm) | 96.8 | 92.5 | 98.4 | 97.9 | 98.5 |
| | Initial thickness of thermally conductive sheet (mm) | 0.15 | 0.1 | 0.50 | 0.30 | 0.20 |
| | Hardness (E hardness) of thermally conductive sheet | 47 | 47 | 47 | 47 | 47 |
| Evaluation item | Thermal resistance value (°C·cm2/W, 40 psi) | 0.117 | 0.105 | 0.221 | 0.157 | 0.138 |
| | Thickness in measurement of thermal resistance value (mm) | 0.090 | 0.062 | 0.345 | 0.209 | 0.151 |
| | D50 (mm)/Initial thickness of thermally conductive sheet (mm) | 0.35 | 0.51 | 0.10 | 0.18 | 0.26 |

[Table 8]

|  |  | Comparative Example 28 | Comparative Example 29 | Comparative Example 30 | Comparative Example 31 | Comparative Example 32 |
|---|---|---|---|---|---|---|
| | Silicone A agent | 91 | 91 | 91 | 91 | 91 |
| | Silicone B agent | 9 | 9 | 9 | 9 | 9 |

(continued)

| | | Comparative Example 28 | Comparative Example 29 | Comparative Example 30 | Comparative Example 31 | Comparative Example 32 |
|---|---|---|---|---|---|---|
| Blend (parts by mass) | n-Decyl tri-methoxysilane | 15 | 15 | 15 | 15 | 15 |
| | Graphitized carbon fiber (1) D50 = 55.1 μm | | | | | |
| | Graphitized carbon fiber (2) D50 = 76.7 μm | | | | | |
| | Graphitized carbon fiber (3) D50 = 82.2 μm | | | | | |
| | Graphitized carbon fiber (4) D50 = 87.0 μm | | | | | |
| | Graphitized carbon fiber (5) D50 = 94.9 μm | | | | | |
| | Graphitized carbon fiber (6) D50 = 99.2 μm | | | | | |
| | Graphitized carbon fiber (7) D50 = 100.8 μm | 160 | 160 | 160 | 160 | 160 |
| | Graphitized carbon fiber (8) D50 = 126.2 μm | 10 | 10 | 10 | 10 | 10 |
| | Flake-like graphite D50 = 15 μm, aspect ratio 10, 550 W/m·K | 20 | 20 | 20 | 20 | 20 |
| | Aluminum powder (Spherical, D50 = 3 μm, Aspect ratio 1 to 1.5) | 243 | 243 | 243 | 243 | 243 |
| | Aluminum oxide (1) (Polygonal, D50 = 0.5 μm, aspect ratio 1) | 30 | 30 | 30 | 30 | 30 |
| | Aluminum oxide (2) (Spherical, D50 = 3 μm, aspect ratio 1) | | | | | |

(continued)

| | | Comparative Example 28 | Comparative Example 29 | Comparative Example 30 | Comparative Example 31 | Comparative Example 32 |
|---|---|---|---|---|---|---|
| Characteristics value | Average fiber length D10 ($\mu$m) | 55.0 | 55.0 | 54.8 | 55.4 | 54.6 |
| | Average fiber length D50 ($\mu$m) | 91.2 | 89.1 | 87.6 | 87.5 | 84.0 |
| | Average fiber length D90 ($\mu$m) | 176.8 | 170.3 | 159.2 | 135.5 | 97.5 |
| | Initial thickness of thermally conductive sheet (mm) | 0.50 | 0.30 | 0.20 | 0.15 | 0.10 |
| | Hardness (E hardness) of thermally conductive sheet | 47 | 47 | 47 | 47 | 47 |
| Evaluation item | Thermal resistance value (°C·cm$^2$/W, 40 psi) | 0.201 | 0.139 | 0.119 | 0.123 | 0.127 |
| | Thickness in measurement of thermal resistance value (mm) | 0.383 | 0.236 | 0.141 | 0.115 | 0.080 |
| | D50 (mm)/Initial thickness of thermally conductive sheet (mm) | 0.18 | 0.30 | 0.44 | 0.58 | 0.84 |

[Example 9, Comparative Examples 33 to 41]

A thermally conductive sheet was prepared in the same manner as in Example 1, except that the composition of the mixed composition was changed to that described in Tables 9 and 10, the thickness of the resulting thermally conductive sheet was adjusted as in Tables 9 and 10, and the resulting sheet-like formed body was not heated.

[Table 9]

| | | Example 9 | Comparative Example 33 | Comparative Example 34 | Comparative Example 35 | Comparative Example 36 |
|---|---|---|---|---|---|---|
| | Silicone A agent | 91 | 91 | 91 | 91 | 91 |
| | Silicone B agent | 9 | 9 | 9 | 9 | 9 |
| | n-Decyl trimethoxysilane | | | | | |
| | Graphitized carbon fiber (1) D50 = 55.1 $\mu$m | | | | | |
| | Graphitized carbon fiber (2) D50 = 76.7 $\mu$m | | | | | |

(continued)

| | | Example 9 | Comparative Example 33 | Comparative Example 34 | Comparative Example 35 | Comparative Example 36 |
|---|---|---|---|---|---|---|
| Blend (parts by mass) | Graphitized carbon fiber (3) D50 = 82.2 μm | 130 | 130 | 130 | 130 | 130 |
| | Graphitized carbon fiber (4) D50 = 87.0 μm | | | | | |
| | Graphitized carbon fiber (5) D50 = 94.9 μm | | | | | |
| | Graphitized carbon fiber (6) D50 = 99.2 μm | | | | | |
| | Graphitized carbon fiber (7) D50 = 100.8 μm | | | | | |
| | Graphitized carbon fiber (8) D50 = 126.2 μm | | | | | |
| | Flake-like graphite D50 = 15 μm, aspect ratio 10, 550 W/m·K | | | | | |
| | Aluminum powder (Spherical, D50 = 3 μm, Aspect ratio 1 to 1.5) | 120 | 120 | 120 | 120 | 120 |
| | Aluminum oxide (1) (Polygonal, D50 = 0.5 μm, aspect ratio 1) | | | | | |
| | Aluminum oxide (2) (Spherical, D50 = 3 μm, aspect ratio 1) | 100 | 100 | 100 | 100 | 100 |
| Characteristics value | Average fiber length D10 (μm) | 46.4 | 46.7 | 46.5 | 46.4 | 46.1 |
| | Average fiber length D50 (μm) | 75.1 | 77.9 | 75.5 | 74.5 | 73.2 |
| | Average fiber length D90 (μm) | 114.5 | 135.4 | 130.5 | 122.5 | 98.5 |
| | Initial thickness of thermally conductive sheet (mm) | 0.15 | 0.50 | 0.30 | 0.20 | 0.10 |
| | Hardness (E hardness) of thermally conductive sheet | 40 | 40 | 40 | 40 | 40 |

(continued)

| | | Example 9 | Comparative Example 33 | Comparative Example 34 | Comparative Example 35 | Comparative Example 36 |
|---|---|---|---|---|---|---|
| Evaluation item | Thermal resistance value (°C·cm$^2$/W, 40 psi) | 0.151 | 0.243 | 0.181 | 0.160 | 0.162 |
| | Thickness in measurement of thermal resistance value (mm) | 0.086 | 0.400 | 0.248 | 0.157 | 0.056 |
| | D50 (mm)/Initial thickness of thermally conductive sheet (mm) | 0.50 | 0.16 | 0.25 | 0.37 | 0.73 |

[Table 10]

| | | Comparative Example 37 | Comparative Example 38 | Comparative Example 39 | Comparative Example 40 | Comparative Example 41 |
|---|---|---|---|---|---|---|
| Blend (parts by mass) | Silicone A agent | 91 | 91 | 91 | 91 | 91 |
| | Silicone B agent | 9 | 9 | 9 | 9 | 9 |
| | n-Decyl trimethoxysilane | | | | | |
| | Graphitized carbon fiber (1) D50 = 55.1 μm | | | | | |
| | Graphitized carbon fiber (2) D50 = 76.7 μm | | | | | |
| | Graphitized carbon fiber (3) D50 = 82.2 μm | | | | | |
| | Graphitized carbon fiber (4) D50 = 87.0 μm | | | | | |
| | Graphitized carbon fiber (5) D50 = 94.9 μm | | | | | |
| | Graphitized carbon fiber (6) D50 = 99.2 μm | | | | | |
| | Graphitized carbon fiber (7) D50 = 100.8 μm | 110 | 110 | 110 | 110 | 110 |
| | Graphitized carbon fiber (8) D50 = 126.2 μm | 30 | 30 | 30 | 30 | 30 |

(continued)

| | | Comparative Example 37 | Comparative Example 38 | Comparative Example 39 | Comparative Example 40 | Comparative Example 41 |
|---|---|---|---|---|---|---|
| | Flake-like graphite D50 = 15 μm, aspect ratio 10, 550 W/m·K | 3 | 3 | 3 | 3 | 3 |
| | Aluminum powder (Spherical, D50 = 3 μm, Aspect ratio 1 to 1.5) | 255 | 255 | 255 | 255 | 255 |
| | Aluminum oxide (1) (Polygonal, D50 = 0.5 μm, aspect ratio 1) | | | | | |
| | Aluminum oxide (2) (Spherical, D50 = 3 μm, aspect ratio 1) | | | | | |
| Characteristics value | Average fiber length D10 (μm) | 61.4 | 62.6 | 62.2 | 62.2 | 60.8 |
| | Average fiber length D50 (μm) | 95.5 | 93.8 | 93.5 | 91.2 | 88.1 |
| | Average fiber length D90 (μm) | 181.6 | 173.9 | 164.4 | 141.2 | 98.2 |
| | Initial thickness of thermally conductive sheet (mm) | 0.50 | 0.30 | 0.20 | 0.15 | 0.10 |
| | Hardness (E hardness) of thermally conductive sheet | 50 | 50 | 50 | 50 | 50 |
| Evaluation item | Thermal resistance value (°C·cm$^2$/W, 40 psi) | 0.236 | 0.168 | 0.151 | 0.155 | 0.165 |
| | Thickness in measurement of thermal resistance value (mm) | 0.428 | 0.262 | 0.163 | 0.119 | 0.083 |
| | D50 (mm)/Initial thickness of thermally conductive sheet (mm) | 0.19 | 0.31 | 0.47 | 0.61 | 0.88 |

It is clear from the above results that, when thermally conductive sheets having the same composition are compared, the thermally conductive sheets prepared in Examples have a low thermal resistance value and can exhibit good thermal conductive properties, whereas the thermally conductive sheets prepared in Comparative Examples have a high thermal resistance value and cannot exhibit good thermal conductive properties.

More specifically, the thermally conductive sheet of Example 1 having D50/T of less than 0.58 had a lower thermal resistance value than that of Comparative Example 4 having D50/T of 0.58 or more, although the thickness of Comparative Example 4 was thinner than that of Example 1. In addition, the thermally conductive sheet of Example 1 had a lower thermal resistance value than that of Comparative Examples 1 to 3 having a thickness of 200 $\mu$m or more, while having D50/T of less than 0.58. Such a tendency was also found in the comparison of Examples 2 to 9 and Comparative Examples 5 to 27 and 33 to 36.

Further, Comparative Examples 28 to 32 and 37 to 41, which are examples using a fibrous filler having a relatively long fiber length, had a thickness of the thermally conductive sheet of 200 $\mu$m or more or D50/T of 0.58 or more, so that the thermal resistance value was not sufficiently reduced even when D50/T was adjusted.

**Claims**

1. A thermally conductive sheet comprising a matrix formed of an organic polymer, and a fibrous filler, a thickness of the thermally conductive sheet being less than 200 $\mu$m, the fibrous filler being oriented in a thickness direction of the thermally conductive sheet, and a ratio (D50/T) of an average fiber length D50 of the fibrous filler to the thickness of the thermally conductive sheet (T) being less than 0.58.

2. The thermally conductive sheet according to claim 1, wherein the average fiber length D50 of the fibrous filler is less than 85 $\mu$m.

3. A thermally conductive sheet comprising a matrix formed of an organic polymer, and a fibrous filler, a thickness of the thermally conductive sheet being less than 200 $\mu$m, the fibrous filler being oriented in a thickness direction of the thermally conductive sheet, and an average fiber length D50 of the fibrous filler being 5 $\mu$m or more and less than 85 $\mu$m.

4. The thermally conductive sheet according to any one of claims 1 to 3, wherein an average fiber length D90 of the fibrous filler is less than 135 $\mu$m.

5. The thermally conductive sheet according to any one of claims 1 to 4, wherein at least one surface of the thermally conductive sheet is a polished surface.

6. The thermally conductive sheet according to any one of claims 1 to 5, wherein the matrix is silicone rubber.

7. The thermally conductive sheet according to any one of claims 1 to 6, wherein the matrix is in an amount of 20 to 50% by volume, and the thermally conductive sheet comprises 30 to 500 parts by mass of the fibrous filler based on 100 parts by mass of the matrix.

8. The thermally conductive sheet according to any one of claims 1 to 7, further comprising a non-anisotropic filler.

9. The thermally conductive sheet according to any one of claims 1 to 8, further comprising a flake-like filler.

10. A method for producing the thermally conductive sheet according to any one of claims 1 to 9, comprising:

    a step of obtaining an oriented formed body from a mixed composition comprising a polymer composition and a fibrous filler, wherein the fibrous filler is oriented along one direction, and
    a step of cutting the oriented formed body into a sheet-like form to obtain a sheet-like formed body.

11. The method for producing the thermally conductive sheet according to claim 10, comprising a step of polishing a surface of the thermally conductive sheet.

Fig. 1

## INTERNATIONAL SEARCH REPORT

| | International application No. |
|---|---|
| | **PCT/JP2023/012651** |

**A. CLASSIFICATION OF SUBJECT MATTER**

*H01L 23/373*(2006.01)i; *H05K 7/20*(2006.01)i
FI: H01L23/36 M; H05K7/20 F

According to International Patent Classification (IPC) or to both national classification and IPC

**B. FIELDS SEARCHED**

Minimum documentation searched (classification system followed by classification symbols)

H01L23/373; H05K7/20

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2018-46073 A (DEXERIALS CORP) 22 March 2018 (2018-03-22) paragraphs [0012]-[0063] | 1-4, 6-8, 10 |
| Y | | 5-11 |
| Y | WO 2017/179318 A1 (POLYMATECH JAPAN CO., LTD.) 19 October 2017 (2017-10-19) paragraphs [0050]-[0051] | 5-11 |
| P, A | WO 2022/070680 A1 (SEKISUI POLYMATECH CO., LTD.) 07 April 2022 (2022-04-07) entire text | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 May 2023** | **23 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

| International application No. |
| --- |
| **PCT/JP2023/012651** |

| Patent document cited in search report | | | Publication date (day/month/year) | Patent family member(s) | | | Publication date (day/month/year) |
| --- | --- | --- | --- | --- | --- | --- | --- |
| JP | 2018-46073 | A | 22 March 2018 | TW | 201826465 | A | |
| | | | | CN | 109891577 | A | |
| WO | 2017/179318 | A1 | 19 October 2017 | US | 2020/0243414 | A1 | |
| | | | | paragraphs [0069]-[0071] | | | |
| | | | | EP | 3419399 | A1 | |
| | | | | CN | 108781524 | A | |
| | | | | KR | 10-2018-0133842 | A | |
| WO | 2022/070680 | A1 | 07 April 2022 | TW | 202214817 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6082777 B
- JP 2017135137 A
- JP 6684408 B